# DEMANDE DE BREVET EUROPEEN

(11) **EP 1 731 899 A1**
(43) Date de publication de la demande: **13.12.2006**
(21) Numéro de dépôt: 05291212.8
(22) Date de dépôt: 06.06.2005
(51) Int. Cl.: G01N 21/88, G01N 21/89, G01R 31/311, H01L 21/66, G01R 31/309

(54) **Système et procédé de controle optique de modules électroniques**

(71) Demandeur: Axalto SA, 92120 Montrouge (FR)
(72) Inventeur: Ros, Frédéric, c/o Axalto SA, 92120 Montrouge (FR); Chardon, Joseph, c/o Axalto SA, 92120 Montrouge (FR); De Brito Gonzalez, Maria , c/o Axalto SA, 92120 Montrouge (FR)
(74) Mandataire: Cassagne, Philippe M.J.

(57) **Abrégé**

L'invention concerne un système et un procédé de contrôle visuel de modules électroniques. Elle vise plus particulièrement le contrôle visuel automatique des modules électroniques, aussi bien sur leur face contact que sur leur face puce, avant leur report dans une carte. Le contrôle de la face contact et celui de la face puce peuvent être simultanés ou indépendants. Le système comprend un premier sous-système (S1) dédié à l'inspection de la face contact des modules et un deuxième sous-système (S2), indépendant, dédié à l'inspection de la face puce des modules. Chaque sous-système (S1 ; S2) comprend au moins deux caméras (11, 12 ; 13, 14), chaque caméra étant apte à visualiser la face qui lui est dédiée de chaque module (21) disposé sur une rangée (22) de modules de la bande microélectronique (20) ; un banc d'éclairage (15 ; 16) de la bande microélectronique (20), et des moyens de calcul (40 ; 45) aptes à délivrer, à partir des images captées par les caméras (11, 12 ; 13, 14), un diagnostic sur la présence ou non de défauts et une caractérisation des défauts.

## Description

La présente invention concerne un système et un procédé de contrôle visuel de modules électroniques.

L'invention se situe dans le domaine de la fabrication des cartes à puce. Elle vise les étapes de fabrication liées à la manipulation des bandes microélectroniques avant le report des modules électroniques dans les cartes et leur encartage. Elle vise plus particulièrement le contrôle visuel automatique des modules électroniques, aussi bien sur leur face contact que sur leur face puce.

La problématique du contrôle visuel des modules électroniques est connue et commune à tous les encarteurs. En effet, l'insertion de modules non fonctionnels dans des corps de carte engendre des opérations inutiles, une lourde perte financière et aussi des réclamations de clients mécontents. De plus, l'encartage de modules fonctionnels mais endommagés par la présence de défauts visuels, tels que des traces de coup, des traces de doigt des rayures ou des micro-déformations par exemple, peut entraîner des réclamations de certains clients jugeant la présence de ces défauts inacceptable. Or des réclamations de clients affectent directement l'image du fabricant de cartes et peuvent mener de surcroît à des pénalisations financières.

Alors que la vérification de la fonctionnalité électrique est entièrement réalisée par des machines de test dédiées, l'inspection visuelle des modules est actuellement réalisée de manière entièrement manuelle.

Une telle inspection manuelle reste longue pour obtenir un diagnostic correct. Un opérateur traite en moyenne 2000 modules à l'heure. D'autre part, une inspection manuelle implique une certaine subjectivité des contrôles si bien que la qualité des contrôles visuels n'est pas toujours très fiable. En particulier, les rendements de l'inspection visuelle varient d'un opérateur à l'autre, si bien que le niveau de qualité des modules n'est pas constant. De même, un même opérateur ne contrôle pas de manière constante les modules, son jugement varie notamment en fonction du type de film mais aussi en fonction de la durée de traitement car la fatigue et l'habitude modifient son comportement. Par conséquent, l'inspection visuelle manuelle ne permet pas de garantir un niveau de qualité constant des modules destinés à être encartés, ce qui peut donc entraîner des réclamations de la part de clients insatisfaits.

Il a déjà été envisagé de réaliser une machine d'inspection de la face contact des modules. Pour cela, la machine compare l'image d'un module à l'image d'un module étalon sans défaut et en déduit la présence ou non d'un défaut. Cette machine est incapable de caractériser les défauts, elle se contente de faire une approche hiérarchique par une discrimination « bon » ou « mauvais ». Une telle approche n'est cependant pas suffisante car elle ne tient pas compte des différentes exigences de qualité des différents clients.

Les systèmes de vision industrielle actuellement commercialisés sont trop généralistes pour fournir une réponse satisfaisante à ce besoin. En effet, de par leur aspect généraliste, ils ne peuvent pas intégrer la connaissance du produit. De plus, la complexité du diagnostic est telle qu'un assemblage de techniques classiques de traitement d'images est insuffisant.

Si l'intérêt d'une machine d'inspection de modules est réel pour des encarteurs, la problématique du diagnostic automatique est complexe à mettre en oeuvre. En effet, la perception des défauts par les hommes est difficile à traduire dans un système automatique. De plus, le système automatique doit présenter une grande flexibilité, tout en restant simple d'utilisation, pour s'adapter à la grande variété de produits existants, telle que la géométrie ou la texture des bandes, ainsi qu'aux exigences qualité des différents clients. Enfin, le système doit permettre un traitement rapide des modules pour assurer une bonne rentabilité et pouvoir être intégré dans une chaîne de production.

De plus, si de nombreux algorithmes de traitement d'images sont disponibles pour résoudre des problèmes liés à la texture et à la reconnaissance des formes, ils restent trop lourds pour faire du traitement temps réel dans des configurations non spécialisées. Une des difficultés à surmonter est donc de proposer des algorithmes très efficaces utilisables à des cadences très élevées, de l'ordre de 40 000 modules / heure au moins, sur des environnements de base et donc de coût très limité.

Aussi, le problème technique objet de la présente invention consiste à proposer un système automatique de contrôle visuel de modules électroniques disposés sur une bande microélectronique, qui permettrait d'inspecter rapidement, de manière indépendante ou simultanée la face contact et la face puce des modules électroniques, de délivrer un diagnostic fiable pour obtenir un niveau de qualité constant, de caractériser les défauts de manière efficace, et qui serait flexible pour s'adapter aux différents types de bandes et aux différentes exigences de niveau de qualité requis par les clients.

La solution au problème technique posé est obtenue, selon la présente invention par le fait que le système comprend un premier sous-système dédié à l'inspection de la face contact des modules, ledit sous-système comprenant :
➢ au moins deux caméras, chaque caméra étant apte à visualiser la face contact de chaque module disposé sur une première rangée de modules, respectivement une deuxième rangée de modules, de la bande microélectronique,
➢ un banc d'éclairage de la bande microélectronique, et
➢ des moyens de calcul aptes à délivrer, à partir des images captées par les caméras, un diagnostic sur la présence ou non de défauts et une caractérisation des défauts.

Selon une autre caractéristique avantageuse, le système comprend en outre un deuxième sous-système dédié à l'inspection de la face puce des modules, ledit deuxième sous-système comprenant :
➢ au moins deux caméras, chaque caméra étant apte à visualiser la face puce de chaque module disposé sur une première rangée de modules, respectivement une deuxième rangée de modules, de la bande microélectronique,
➢ un banc d'éclairage de la bande microélectronique et
➢ des moyens de calcul aptes à délivrer, à partir des images captées par les caméras, un diagnostic sur la présence ou non de défauts et une caractérisation des défauts.

Selon encore une autre caractéristique avantageuse, le système comporte en outre un support de bande commun aux deux sous-systèmes.

Le système est adaptable puisqu'il est capable de gérer n'importe quel type de bande microélectronique. Ce système présente en outre une cadence régulière de traitement des modules très supérieure à celle d'un homme, puisqu'elle est de l'ordre de 40000 modules par heure. Le système permet également de garantir un niveau de qualité constant et permet de s'ajuster au niveau de qualité requis par un client et donc de ne faire ni de production de sous-qualité ni de production de sur-qualité. Enfin, compte tenu de tous les avantages cités, les coûts de traitement sont considérablement réduits comparativement à l'inspection manuelle.

Corrélativement, l'invention porte également sur une méthode de contrôle visuel automatique de modules électroniques disposés sur une bande microélectronique.

Cette méthode est particulièrement remarquable en ce qu'elle comprend les étapes consistant à :
- paramétrer la bande à analyser à partir de sa géométrie, de son apparence et d'un niveau de qualité requis,
- définir des zones d'inspection par rapport à des index de référence, chaque zone d'inspection correspondant respectivement à la surface d'un module à analyser, et
- pour chaque zone d'inspection :
   - détecter la présence d'un défaut,
   - estimer les dimensions du défaut détecté,
   - caractériser le défaut détecté et
   - émettre un diagnostic sur le statut du module analysé.

Le procédé selon l'invention présente une grande flexibilité sur la manière d'appréhender le niveau de qualité requis pour un produit donné. Le raisonnement aboutissant au diagnostic est calqué sur les raisonnements des opérateurs.

D'autres particularités et avantages de l'invention apparaîtront à la lecture de la description suivante faite à titre d'exemple illustratif et non limitatif, en référence aux figures annexées qui représentent :
- la figure 1A, une vue schématique en coupe d'un système d'inspection selon l'invention,
- la figure 1B, une vue schématique de la position respective des caméras du système de la figure 1A par rapport à une bande microélectronique,
- la figure 2A, une vue schématique d'un moyen d'éclairage des index de référence, utilisé dans le système de la figure 1A,
- la figure 2B, une vue schématique d'un moyen d'éclairage des faces des modules, utilisé dans le système de la figure 1A,
- la figure 3, un schéma simplifié de l'agencement interne des moyens de calcul et des interfaces de traitement constituant le coeur du système de la figure 1A,
- la figure 4, un organigramme schématisant les principales étapes d'un procédé de contrôle visuel selon l'invention,
- la figure 5, une vue d'une zone d'inspection d'une face contact décomposée en zones élémentaires,
- la figure 6, un schéma d'une interface discursive directement utilisable par un opérateur et traduisant de manière qualitative des valeurs numériques des notions de longueur et de taille de rayures,
- la figure 7, un exemple possible d'une matrice de visibilité liée à la notion de contraste,
- la figure 8, un exemple possible d'une matrice de co-occurrence liée à la notion de texture,
- la figure 9, un exemple possible d'une interface administrateur traduisant en valeurs numériques des notions de tailles et de longueur de rayures définies dans l'interface opérateur de la figure 6.

L'invention consiste à proposer un système et un procédé automatique de contrôle visuel de la face contact et de la face puce des modules électronique. Grâce à un paramétrage préalable de ce système, il est possible d'inspecter l'une ou l'autre des faces de manière indépendante ou de les inspecter toutes les deux de manière simultanée.

L'inspection de la face contact consiste à détecter la présence de défauts tels que des coups, des rayures ou des traces de pollution par exemple, et de caractériser ces défauts.

L'inspection de la face puce consiste à déterminer si la résine de protection a tourné ou s'est décalé et si c'est le cas, à vérifier que l'angle de rotation autorisé ou que la distance de déplacement autorisée n'ont pas été dépassé. Elle consiste aussi à vérifier que la résine n'a pas débordé au-delà d'une zone de débordement permise ou encore qu'un minimum de déviateurs de contraintes ne soit pas obturé par de la résine. Elle consiste enfin à visualiser la présence de défauts apparus dans la résine de protection, tels que des coups ou des bulles par exemple, et à caractériser ces défauts. L'aspect de la résine de protection n'est pas constant, les bandes n'ayant pas la même texture ni la même luminosité. Seules, l'introduction de la connaissance liée à la géométrie du produit et l'utilisation d'heuristiques liées à la texture de la résine permettent de fournir un diagnostic consistant pour toutes les configurations. Le cas d'une configuration de bande de type FCI T2, commercialisée par la société FCI, est très significatif. Cette bande est en effet très sombre et la distribution des niveaux de luminosité se recouvre partiellement avec celle correspondant à la résine dans le cas le plus standard.

La description suivante traite essentiellement de l'inspection de la face contact. Toutefois, il ne faut pas oublier que le système et le procédé décrits sont également adaptés à l'inspection de la face puce.

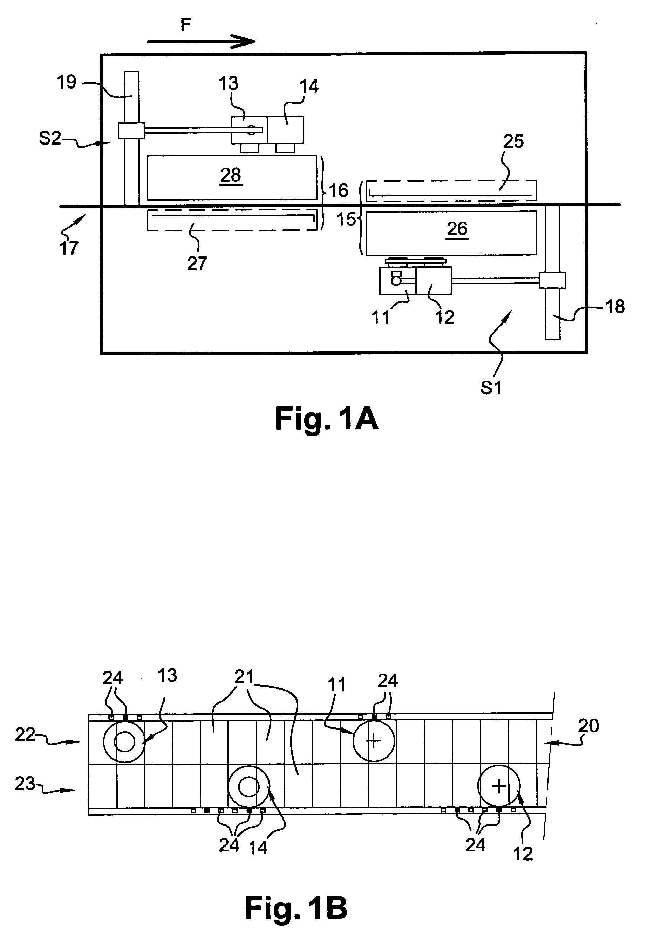

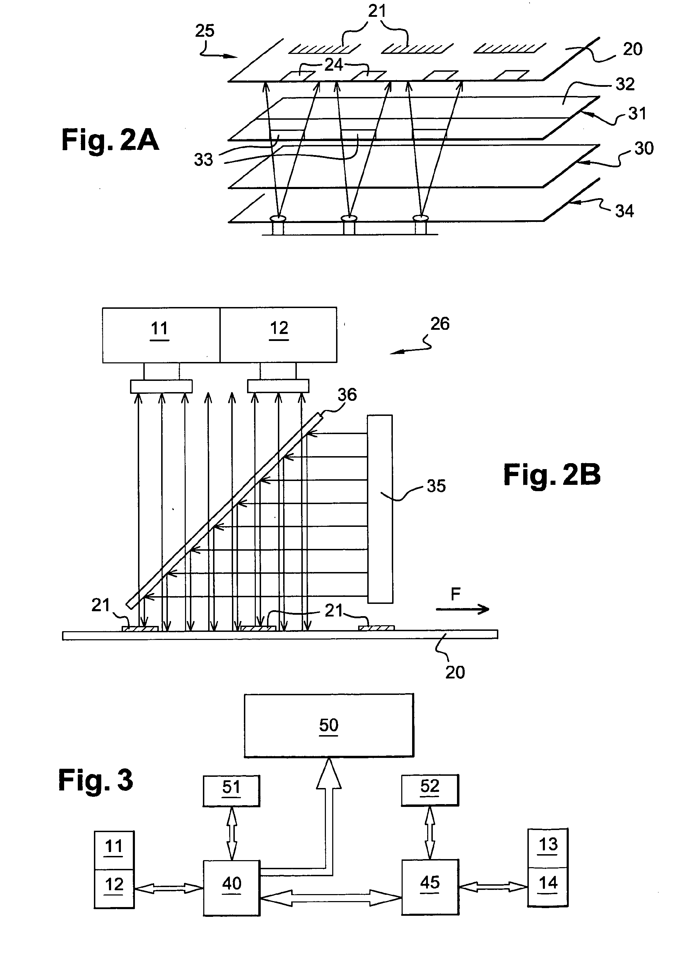

Le système automatique de contrôle visuel de modules électroniques, tel que schématisé sur la figure 1A, comprend deux sous-systèmes S1 et S2 indépendants. Un premier sous-système S1 est dédié à l'inspection de la face contact des modules, et l'autre S2 est dédié à l'inspection de la face puce des modules. Chacun des deux sous-systèmes comprend respectivement : deux caméras 11, 12 et 13, 14 aptes à visualiser respectivement la face d'un module disposé sur une des deux rangées de modules composant la bande microélectronique. Chaque sous-système S1, S2 comprend en outre un banc d'éclairage 15, respectivement 16, de la bande microélectronique, et des moyens de calcul aptes à délivrer, à partir des images captées par les caméras, un diagnostic sur la présence ou non de défauts et une caractérisation des défauts détectés. Ces moyens de calcul sont constitués, pour chaque sous-système, par un ordinateur 40, respectivement 45, par exemple, tel que représenté sur la figure 3. Chaque moyen de calcul 40, respectivement 45, de chaque sous-système S1, S2, est relié aux deux cameras 11, 12, respectivement 13, 14. Le système comporte en outre un support de bande 17 commun aux deux sous systèmes S1, S2. La bande microélectronique défile pas à pas dans le sens de défilement indiqué par la flèche F sur la figure 1A.

De préférence, les deux caméras 11, 12, respectivement 13, 14 de chaque sous-système S1, S2 sont maintenues fixement sur un même support commun 18, respectivement 19. De plus, elles sont de préférence montées selon une architecture de type pipeline, de manière à ce que les images captées par les deux caméras 11, 12, respectivement 13, 14, puissent être traitées simultanément. Les deux caméras sont des caméras standard basse résolution, car elles permettent d'obtenir un signal suffisant, c'est-à-dire de capturer une image contenant suffisamment de détails pour mettre en avant la présence de défauts.

La figure 1B schématise une bande microélectronique 20 et la position des caméras 11, 12 et 13, 14 par rapport aux modules électroniques 21 à inspecter. La bande comporte en fait, sur toute sa longueur, deux rangées 22, 23 de modules électroniques représentés par des rectangles 21 sur la figure 1B. La bande 20 comporte également des trous débouchant formant des index de référence 24 disposés le long de ses bords longitudinaux. La présence de ces index 24 de référence est très importante pour permettre un bon alignement de la bande et pour permettre une bonne définition des zones d'inspection par les caméras. Deux caméras 11, 12 du premier sous-système S1, disposées au-dessous de la bande par exemple, inspectent la face contact des modules, alors que deux autres caméras 13, 14 du deuxième sous-système S2, disposées au-dessus de la bande 20 par exemple, inspectent la face puce des modules. Toutes les caméras sont décalées les unes par rapport aux autres non seulement pour des raisons d'intégration mécanique dans une machine de manipulation des bandes, mais aussi pour que le champ visuel de chacune ne soit pas perturbé par l'environnement des autres.

Le banc d'éclairage 15, respectivement 16, utilisé dans chaque sous-système S1, S2 permet à la fois de réaliser l'alignement de la bande microélectronique et de permettre un contrôle visuel efficace. Pour cela, le banc d'éclairage comprend un premier moyen 25, respectivement 27, de rétro-éclairage dédié à l'éclairage des index de référence 24 et un deuxième moyen 26, respectivement 28, d'éclairage dédié à la mise en évidence des défauts visuels de la face contact ou de la face puce d'un module. Un moyen de pilotage des deux moyens d'éclairage, non représenté sur la figure 1A, permet par ailleurs de trouver le contexte d'éclairage d'une nouvelle bande et de régler avec une grande flexibilité d'une part l'éclairage des index, d'autre part l'éclairage de la bande, tout en tenant compte du temps d'intégration de la lumière par les caméras.

La figure 2A schématise le moyen 25, respectivement 27 de retro-éclairage dédié aux index de référence. Ce moyen comporte une plaque de diffusion 30 pour permettre de diffuser la lumière. Cette plaque de diffusion est par exemple réalisée en plexiglas. Une plaque filtre 31 est munie, de part et d'autre d'éléments opaques 32, de trous traversant 33. Ainsi, la plaque filtre 31 permet de filtrer la lumière au niveau des surfaces des modules 21 à contrôler, grâce aux éléments opaques 32 disposés en regard des modules, et de laisser passer la lumière au travers des index de référence 24 de la bande 20, grâce aux trous débouchant 33. Une plaque d'éclairage 34, à base de diodes électroluminescentes par exemple, permet d'éclairer les plaques de diffusion 30, de filtre 31 et la bande 20 de manière uniforme. Ce moyen de rétro éclairage permet donc un éclairage optimal des index, adapté à toutes les bandes et ne perturbant pas l'aspect des modules à inspecter.

Le moyen 26, respectivement 28, d'éclairage dédié aux défauts visuels des modules, tel que schématisé sur la figure 2B, comprend un moyen 35 de diffusion axiale de la lumière qui permet d'éclairer la zone des deux caméras 11, 12, respectivement 13, 14, montées en pipeline. Un miroir semi-réfléchissant 36 renvoie les faisceaux lumineux d'une part vers les caméras 11, 12 et d'autre part vers les modules 21 à observer.

Ainsi, le premier moyen 25, 27 de retro-éclairage des index éclaire une face de la bande opposée à la face éclairée par le deuxième moyen 26, 28 d'éclairage dédié aux défauts visuels.

La figure 3 schématise, de manière simplifiée, l'agencement interne du système, et plus particulièrement les moyens de calcul et leurs connexions avec les caméras et avec une unité centrale de gestion. Les deux caméras 11, 12 du premier sous-système S1 communiquent avec un premier moyen de calcul 40. Les deux caméras 13, 14 du deuxième sous-système S2 communiquent avec un deuxième moyen de calcul 45. Ces moyens de calcul 40, 45 implémentent des moyens logiciels mettant en oeuvre des algorithmes dédiés à la détection de défauts visuels. Chaque moyen de calcul 40, respectivement 45, est relié à un moyen de gestion dédié 51, respectivement 52, comportant des interfaces homme/machine ainsi que les bases de données nécessaires aux étapes de paramétrage puis de détection de la présence de défauts visuels sur les deux faces des modules analysés et à la caractérisation de ces défauts. Chaque moyen de calcul 40, 45 et son moyen de gestion 51, 52 associé peut par exemple être constitué par un ordinateur. Le premier moyen de calcul 40 par exemple collecte les données du deuxième moyen de calcul 45 puis transmet toutes les données issues des calculs à une unité centrale de gestion 50. Cette unité de gestion 50 établit un lien unique avec la machine de manipulation de bandes dans laquelle le système est intégré, pour synchroniser l'avancement de la bande et la livraison des différents diagnostics. A chaque pas d'avancement, chaque caméra capture l'image d'un module différent sur la bande et permet de délivrer un résultat intermédiaire grâce au moyen de calcul 40, 45 et au moyen de gestion 51, 52 dédié.

L'unité centrale de gestion 50 a donc pour rôle de concaténer les informations de chaque unité de calcul 40, 45 pour les rendre intelligibles pour la machine de manipulation de bandes en gérant notamment l'architecture en pipeline des caméras. Au niveau des diagnostics fournis à la machine, le module est soit bon, soit mauvais, soit très mauvais. Une succession de modules très mauvais entraîne un raccord de bande, alors qu'un module mauvais entraîne une invalidation du module.

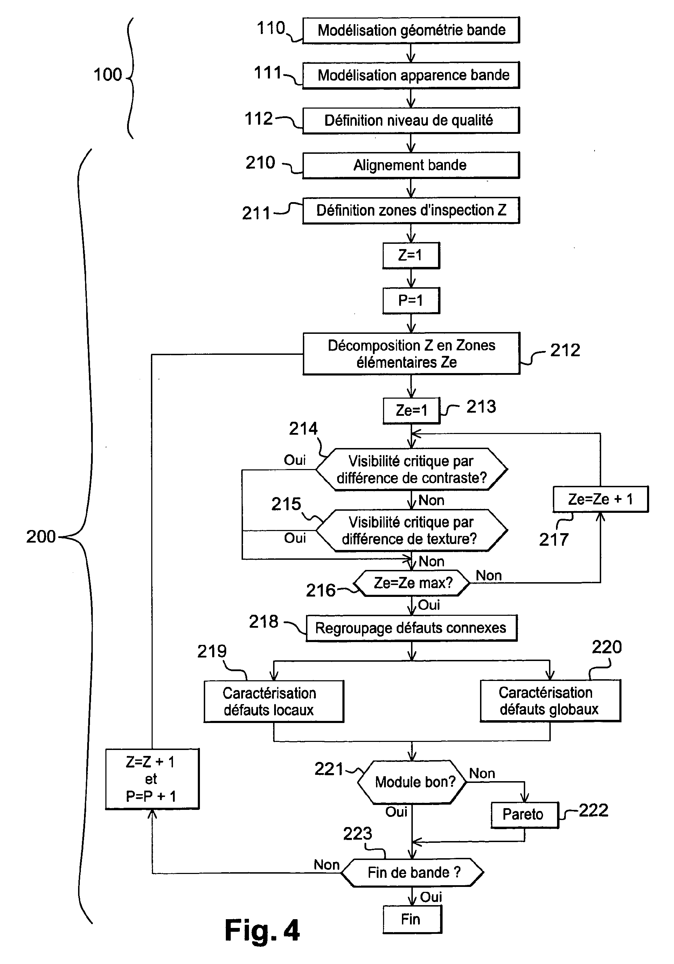

Le système de contrôle visuel automatique qui vient d'être décrit permet de mettre en oeuvre un procédé automatique de contrôle visuel de modules électroniques dont les principales étapes sont schématisées sur l'organigramme de la figure 4.

Le procédé comprend deux phases : une phase préalable de paramétrage 100, et une autre phase de diagnostic 200. Ces deux phases sont mises en oeuvre par des moyens logiciels stockés dans au moins un support d'enregistrement, qui peut être un support matériel, de type CD-Rom, disquette ou disque dur, ou bien un support transmissible tel qu'un signal électrique, optique ou radio. Les moyens logiciels sont implémentés par l'unité centrale de gestion 50, par les moyens de gestion 51,52 et par les moyens de calcul 40, 45 pour aboutir au diagnostic final.

Pour simplifier les explications, les étapes décrites en référence à la figure 4, correspondent aux étapes effectuées suite à la visualisation, par une seule caméra 11 d'un premier sous-système S1, de modules disposés sur une même rangée 22 d'une bande microélectronique 20. Il ne faut pas oublier qu'une deuxième caméra 12 du même sous-système S1 visualise les modules de la deuxième rangée 23 de la bande 20, et que les deux caméras 11, 12 étant montées selon une architecture pipeline, le traitement des images visualisées est réalisé de manière simultanée par le moyen de calcul 40 et son moyen de gestion dédié 51.

La perception globale des défauts, c'est à dire la perception sur toute la surface d'un module, est principalement liée à la notion de visibilité et, à un degré inférieur, à la notion de taille ou de forme. En revanche, la perception locale des défauts, c'est-à-dire la perception sur des portions de la surface d'un module, combine de manière équilibrée la notion de taille et de forme et la notion de visibilité. Ainsi, par exemple, une rayure très fine mais longue va tout de suite être repérée de par sa forme géométrique et à un degré moindre par sa taille et sa visibilité, ces deux facteurs n'étant pas prédominant dans ce cas là.

Pour un opérateur, la perception des défauts est plutôt qualitative que quantitative dans le sens où un opérateur ne caractérise jamais un défaut par des mesures, mais plutôt par des impressions générales de type « petit », « fin », « inratable », etc...

La caractérisation des défauts passe donc par une modélisation des défauts qui est basée sur une numérisation du raisonnement des opérateurs qui privilégie l'interprétation qualitative du défaut plutôt que quantitative. Contrairement à une problématique de défauts « sans ambiguïté » et « mesurables » que l'on retrouve par exemple sur les surfaces des disques laser ou CD-Rom, car la surface est très brillante, uniforme et identique d'un produit à l'autre, la perception et la caractérisation des défauts sur les modules sont plus complexes à diagnostiquer. En effet, un même défaut « géométrique » n'est pas perçu de la même manière d'une bande à une autre.

Ainsi, une typologie à trois catégories de défauts locaux est définie : une première catégorie, dite rayure, concerne des défauts plutôt longilignes et plus ou moins « visibles », une deuxième catégorie, dite marque, concerne des défauts plutôt compacts mais d'une « visibilité » moindre, et enfin, une troisième catégorie, dite pollution, concerne des défauts également compacts mais d'une « visibilité » encore moins évidente que pour la catégorie marque.

Une typologie à deux catégories est aussi adaptée dans une approche de perception globale des défauts. Dans ce cas, les catégories marque et pollution de l'approche locale sont confondues. En effet, si localement un défaut a bien été identifié de part sa géométrie, il peut ne pas être identifié comme suffisamment sérieux au sens de sa visibilité et donc non identifié. Cependant, il peut, lorsqu'il est combiné à d'autres défauts locaux faire partie d'une perception globale du module en défaut.

Une première étape 110 de la phase de paramétrage 100 consiste à modéliser la géométrie de la bande microélectronique sous contrôle.

La géométrie d'une bande correspond aux données du fabricant avec toutes les côtes nominales associées. La modélisation de la géométrie de la bande repose sur un masquage préalable et une décomposition de la zone d'inspection, correspondant à la surface d'un module, en zones élémentaires. Ces deux éléments ont comme référence commune les index 24 de la bande. La notion de masque permet de considérer un module de manière unitaire et d'inhiber du diagnostic les zones masquées, telles que par exemple les zones inter-pistes etc. Ce procédé de masquage simplifie la phase de paramétrage. En effet, sans ce procédé de masquage automatique, l'utilisateur doit lui-même sélectionner autant de zones d'intérêt que de parties ne contenant pas d'inter pistes. Une telle sélection manuelle est lente, présente des risques d'erreur, et n'est pas répétable. Grâce à l'étape de masquage automatique, un masque est fabriqué une seule fois par géométrie de bande et sur la base de la même référence que la zone d'inspection, c'est-à-dire sur la base des trous d'index 24, ce qui permet de reporter le masque ainsi paramétré sur les images des modules en inspection, visualisés par les caméras.

La décomposition en zones élémentaires est très utile et pertinente : elle permet une représentation macroscopique du module et une plus grande efficacité et rapidité dans le traitement. Elle permet aussi d'inhiber le traitement de certaines zones élémentaires dans le cas où elles ne sont pas importantes pour un client donné.

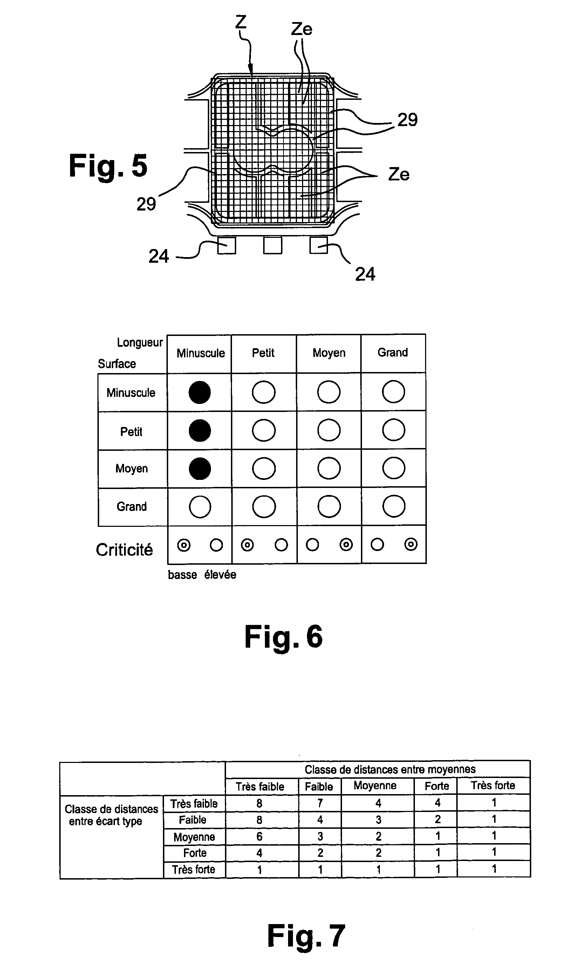

La figure 5 illustre cette étape. Elle représente en effet l'image d'une face contact d'un module découpée en zones élémentaires individualisées, en grisées, chacune en référence aux index 24 de la bande, et dont les zones inter pistes 29, en noir, à ne pas contrôler sont masquées. Concernant la face puce, les masques sont essentiellement disposés sur les déviateurs de contraintes, c'est-à-dire autour de la zone de protection par la résine, et la zone d'inspection, située à l'intérieur de ces déviateurs de contrainte, est découpée en zones élémentaires.

Par ailleurs, les bandes d'un même fabricant peuvent avoir la même géométrie, mais un aspect visuel différent, c'est-à-dire une apparence différente, du fait du procédé de fabrication ou du matériau de constitution de la bande. L'homme a la capacité de faire abstraction d'éléments non caractéristiques du module de part sa capacité à sélectionner l'information pertinente qu'il doit étudier. Par exemple, la géométrie des bandes à savoir les dimensions nominales des bandes et les positions et formes plus ou moins complexes des inter pistes des modules sont très variables d'un module à l'autre. La création d'une nouvelle bande doit pourtant rester quelque chose de simple et rapide à faire sachant qu'il n'y a aucun intérêt à inspecter des inter pistes. Pour une même géométrie de bandes, il peut y avoir plusieurs textures allant du très mat au très brillant avec des matériaux différents, tels que le palladium ou l'or par exemple, imposant donc une adaptabilité de la lumière envoyée sur le module.

L'étape suivante 111 consiste donc à modéliser l'apparence de la bande. Le banc d'éclairage 15, respectivement 16, est donc réglé de manière à obtenir une configuration optique optimale, c'est-à-dire une configuration évitant une saturation des images tout en permettant une bonne visibilité des index 24.

Les paramètres liés à la géométrie des bandes sont stockés dans un premier support d'enregistrement, de type base de données, et les paramètres liés à l'apparence des bandes sont stockés dans un deuxième support d'enregistrement, de type base de données. Ces deux bases de données sont gérées au niveau administrateur de la machine de contrôle visuel, c'est-à-dire par une interface administrateur disposée dans le moyen de gestion 51, respectivement 52, associé au moyen de calcul 40, respectivement 45, d'un sous-système S1, respectivement S2, si bien que l'utilisateur du système de contrôle visuel n'y a pas directement accès.

Ensuite, un niveau de qualité est définit en tenant compte des exigences du client (étape 112). Un niveau de qualité correspond aux différents critères de qualité qui définissent, pour une production donnée, ce qu'est un bon ou un mauvais module. Il s'appuie sur les propriétés d'apparence et de géométrique des bandes.

Les paramètres traduisant le niveau de qualité requis sont eux-aussi de préférence stockés dans une troisième base de données qui est gérée directement par l'opérateur utilisant la machine de contrôle visuel, c'est-à-dire par une interface opérateur associée au moyen de gestion 51, respectivement 52, du sous-système S1, respectivement S2.

Les exigences du client sont par exemple spécifiées par l'intermédiaire de l'utilisateur du système au moyen d'une interface discursive telle que représentée sur la figure 6, pour la définition d'un défaut au travers d'une rayure. Cette interface permet à l'utilisateur de spécifier, en grisé, toutes les configurations qui correspondent à un défaut, et en noir, les configurations qui correspondent à un niveau de qualité accepté. La notion de criticité « basse » et « élevée » exprime comment la visibilité doit être prise en compte avec des attributs géométriques définis dans l'interface administrateur.

Ainsi, une image de module combinée à l'ensemble des paramètres désignant le niveau de qualité requis permet d'établir la structure utilisée pour le diagnostic.

Les étapes préalables de paramétrage ayant été réalisées, la phase de diagnostic 200 proprement dite sur une bande à analyser peut commencer

Une première étape 210 de cette phase de diagnostic 200 consiste à vérifier et éventuellement corriger l'alignement de la bande microélectronique. Le placement automatique des bandes dans un mode pas à pas n'est jamais parfaitement répétable surtout à haute cadence et donc nécessite une procédure d'alignement imposant précision et rapidité. Cette procédure d'alignement doit être performante quelles que soient les bandes et leur apparence. Elle permet en effet de superposer parfaitement les attributs de l'image de référence avec ceux de l'image étudiée. Cette étape se base sur la recherche de la position des index de référence éclairés par le moyen de rétro-éclairage dédié 25, 27. Ensuite, à partir de la position détectée des index de référence 24 de la bande à analyser, le système défini, de manière relative, les zones d'inspection Z correspondant respectivement à la surface d'un module à contrôler (étape 211).

Pour chacune des zones d'inspection Z ainsi définie, les étapes menant au diagnostic sont activées. Ainsi, chaque zone d'inspection Z à contrôler est décomposée en zones élémentaires Ze1 à Zemax (étape 212) et un masque est appliqué sur les zones à ne pas contrôler telles que les inter-pistes par exemple.

Pour chaque zone élémentaire Ze (étape 213) d'une même zone d'inspection Z, différentes étapes sont mises en oeuvre pour détecter la présence de défauts locaux en analysant notamment la différence de contraste et la différence de texture.

Pour se rapprocher de l'expertise humaine, un défaut local se caractérise par des lois très simplistes à trois paramètres pour les rayures et à deux pour les marques et les pollutions. Ainsi, pour une rayure par exemple, la définition accessible à l'utilisateur du système, sur la base des paramètres définis par lui-même dans l'interface discursive représentée à la figure 6, est la suivante : « Si le défaut présente une longueur moyenne, une surface petite et une visibilité critique alors le module est mauvais ». De même, pour les marques et les pollutions, la définition accessible est : « Si le défaut présente une grande surface et petite visibilité alors le module est mauvais ». Pour déterminer la visibilité et la taille des défauts locaux, chaque zone élémentaire Ze est donc analysée au travers d'un filtre de contraste (étape 214) puis au travers d'un filtre de texture (étape 215).

A l'étape 214, chaque zone élémentaire est identifiée à travers un filtre de contraste. Un différentiel de contraste permet en effet de traduire la notion de visibilité moyenne. Le système de contrôle visuel détecte donc, dans chaque zone élémentaire Ze analysée, s'il existe une différence de contraste qui serait liée à la présence d'un défaut entraînant un différentiel de luminosité. Les gros défauts, tels qu'un coup sur le module ou une rayure profonde par exemple, peuvent être très facilement caractérisés par la notion de contraste. En revanche, les petits défauts ou certaines rayures sont difficilement perceptibles par la seule notion de contraste car la variabilité du contraste que ces défauts génèrent est facilement confondue avec la variabilité naturelle du contraste entre deux bons modules. Ceci met en avant une limite essentielle des systèmes classiques du marché basée sur une segmentation même sophistiquée de la distribution de la luminosité.

Une étude statistique sur un panel représentatif de bandes montre qu'une zone locale d'une surface de 1 à 2 mm² assure à la fois une distribution stable des niveaux de gris d'un module à l'autre et est suffisamment faible pour mettre en évidence des petits défauts. Cette étude montre aussi que la distribution s'apparente à une distribution sensiblement gaussienne. Le fait de considérer comme éléments caractéristiques la moyenne et l'écart type permet de construire une approche simple de la notion de visibilité.

De la même manière que l'on peut décrire ce qu'est une rayure à l'aide du discursif proche de l'expertise humaine, il est possible de décrire la notion de visibilité par contraste par le type de loi discursive suivante : si la « distance » entre la moyenne locale du module testé et du(des) module(s) de référence est « grande » et si la « distance » entre l'écart type local du module testé et du (des) module(s) de référence est « petite » alors la visibilité locale atteint un niveau 3 de criticité. En poursuivant ce raisonnement, une matrice de référence unique entre les distances entre moyenne et écart type, illustrée sur la figure 7, peut être développée pour permettre de caractériser dans cet espace d'attributs à deux dimensions la définition de la visibilité. La « distance » concernant les écart-types correspond à une distance euclidienne alors que la distance au niveau des moyennes est une distance euclidienne compensée par un décalage mettant en avant la dispersion naturelle des moyennes pour un bon produit, ceci dérivant d'un calcul statistique préliminaire.

En attribuant des correspondances « discursif /numérique », il est donc possible de pondérer la sévérité associée à la visibilité et donc de s'accorder à une exigence client. Des classes de correspondances sont établies par défaut de criticité très sévère à tolérant et peuvent être utilisées comme nominales pour des ajustements ultérieurs.

Chaque zone élémentaire est donc affectée d'un statut bon ou mauvais selon la distribution des niveaux de gris. Le statut mauvais est associé à un niveau de gravité globale et une estimation quantitative de la surface en défaut de la zone élémentaire Ze. Cette différentiation du contraste permet de mettre en évidence la présence de défauts de type marque ou pollution. Elle reste toutefois insuffisante pour la caractérisation des rayures affectant plutôt l'aspect de texture. C'est cependant la combinaison de ces notions qui traduit la notion de visibilité.

Une étape ultérieure 215 consiste donc a analyser chaque zone élémentaire Ze, dont le statut a été déclaré bon par le premier filtre de contraste (étape 214), au moyen d'un filtre de texture. Le filtre de texture permet de mettre en avant des défauts non vus par le filtre contraste, généralement des défauts de type « petite rayure » ou « petits coups » ne ressortant que très peu malgré leur présence. Cette étape n'est pas systématique. En effet, dans le cas où un défaut de type contraste a été détecté, il n'est pas nécessaire de rajouter du temps de traitement inutilement, et on passe alors directement à l'étape ultérieure 216.

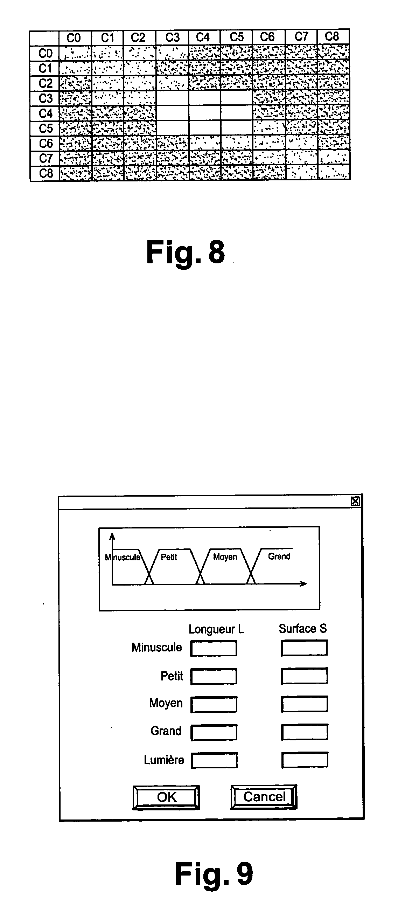

Le système de contrôle visuel applique donc un filtre de texture pour détecter une éventuelle différence de gradient dans chaque zone élémentaire analysée. Les lois de Weber expriment la sensibilité de l'oeil aux différences de niveaux de gris suivant des plages de niveaux. La texture d'un module est du type plutôt continue et répétable ce qui permet une caractérisation par des outils de traitement d'images dédiés comme les matrices de cooccurrence très connues dans la littérature du traitement d'image. Une matrice de cooccurrence moyennant deux directions d'images perpendiculaires avec des classes choisies C0-Cn de manière adaptative, caractérise un bon module et permet de révéler grâce à deux niveaux d'indicateurs de visibilité la présence de défauts non perceptible au sens du contraste. La figure 8 illustre une telle matrice de cooccurrence. C0 à C8 sont des classes de niveaux de gris calculés de manière automatique. Chaque case Cij représente le nombre d'occurrence normalisé entre une classe Ci et la classe Cj, suivant deux directions orthogonales et une distance de 1 pixel. Si par exemple, il y a 200 fois un pixel de niveau Ci positionné à une distance de un pixel de niveau Cj, alors la classe Cj sera égale à 200. La texture représentative d'un module sans défaut est marquée majoritairement à partir des cases formées par C3, C4, C5 qui sont mises en évidence par des traits pointillés. Le niveau d'occurrences dans les autres cases révèle la présence de défauts et permet aussi d'en caractériser la gravité.

Chaque zone élémentaire Ze d'une zone d'inspection Z est ainsi analysée à travers les filtres de contraste et de texture jusqu'à ce que toutes les zones élémentaires Ze aient été analysées, suivant les étapes 214 à 217.

Un algorithme de remplissage connexe appliqué sur les zones élémentaires adjacentes, permet ensuite de regrouper les zones connexes dont le statut a été diagnostiqué mauvais (étape 218). Ce travail de regroupage des zones connexes en défaut est très rapide à effectuer et permet de définir une vue macroscopique des défauts qui correspond plus à l'interprétabilité humaine.

Chaque groupe de défauts connexes, appartenant à des zones élémentaires Ze adjacentes, est ensuite caractérisé (étapes 219 et 220). En fait, un premier niveau de décision permet de caractériser les défauts connexes locaux (étapes 219), tandis qu'un deuxième niveau de décision permet de caractériser les défauts connexes à un niveau global (étape 220). Le processus de caractérisation essaye d'imiter un comportement humain et intuitif. L'oeil est très sensible à un défaut ponctuel, tel qu'un petit coup, bien visible mais l'ignore lorsqu'il est moins visible. Par conséquent, le premier type de décision (219), au niveau local, permet de déterminer un défaut et aussi de le caractériser, par exemple une rayure ou un coup. Lorsqu'il y a plusieurs petits coups moins visibles, l'oeil est globalement sensible à une « pollution » de défauts sans pouvoir bien faire de distinction sur la caractéristique du défaut. L'opérateur en déduit alors que le module est « sale ». Dans ce cas, le deuxième type de décision (220), au niveau global, permet de déterminer ce type de pollution.

La résultante de ces deux niveaux de décision aboutit à un diagnostic sur le statut bon ou mauvais du module (étape 221). Pour cela, chaque groupe de défauts connexes est analysé par trois systèmes de décision respectivement pour les marques, les pollutions et les rayures. La géométrie et le degré de visibilité d'un groupe de défauts connexes permettent alors de désigner un statut bon /mauvais du module et son appartenance ou non à l'une des trois catégories caractéristiques. Pour cela, les dimensions, c'est-à-dire la longueur et la surface, des défauts connexes sont sommées.

La traduction numérique des notions mesurables de longueurs et de tailles pour les rayures est réalisée au niveau d'une interface administrateur non accessible à l'utilisateur de la machine, et telle qu'illustrée sur la figure 9. Cette démarche intuitive s'appuie sur la connaissance des opérateurs et l'espace réservé aux différentes caractéristiques perceptibles par un opérateur est découpé en partitions de type « minuscule », « petit », « moyen », « grand » en fonction de la longueur L ou de la surface S des défauts détectés. L'ambiguïté de l'analyse des opérateurs dans la désignation des valeurs frontières est prise en compte par l'utilisation de partitions floues trapézoïdales.

Selon les dimensions estimées des défauts connexes, c'est-à-dire selon la longueur, la surface, la visibilité etc, le système les compare aux exigences qualité du client préalablement enregistrées au moment du paramétrage du système (étape 221). Si le groupe connexe correspond à un défaut jugé inacceptable par le client, le module portant le défaut est alors diagnostiqué de mauvais. Le système de décision globale peut diagnostiquer un module mauvais alors que localement le diagnostic était bon.

Le système fournit par ailleurs des éléments sur la qualification des défauts, tels que par exemple un défaut local, global, une rayure, une marque, une pollution etc , ce qui permet d'établir un PARETO global par lot de production (étape 222). Les PARETO ainsi créés pendant l'inspection des modules d'un lot de production permettent, entre autre, d'améliorer certains paramètres de procédés de fabrication liés à une production donnée.

A chaque analyse s'adjoint un diagnostic de fin de bande (étape 223). Une fin de bande se caractérise par la présence d'un film plastic blanc ou transparent à la place des modules. Un double critère de texture et de luminosité de la surface d'inspection permet de garantir le diagnostic de présence ou absence de bande.

Les étapes de diagnostic 212 à 222 sont ainsi répétées tout au long du défilement pas à pas P de la bande microélectronique jusqu'à la détection de la fin de la bande.

Le système qui vient d'être décrit fournit aussi des moyens pour paramétrer facilement le système. A partir d'une banque d'images de bons modules enregistrés sur la machine, il permet d'extraire des indices statistiques liés à la variabilité naturelle entre les modules et à leur texture.

Les modes de réalisation qui viennent d'être décrits ne sont que des exemples illustratifs auxquels l'invention ne se limite pas. En effet, de multiples variantes des modes de réalisation décrits ci-dessus peuvent être envisagés tout en restant dans le cadre de l'invention.

## Revendications

1. Système de contrôle visuel automatique de modules électroniques (21) d'une bande microélectronique (20), **caractérisé en ce qu'**il comprend un premier sous-système (S1) dédié à l'inspection de la face contact des modules (21), ledit premier sous-système (S1) comprenant :
➢ au moins deux caméras (11, 12), chaque caméra étant apte à visualiser la face contact de chaque module (21) disposé sur une première rangée (22) de modules, respectivement une deuxième rangée (23) de modules, de la bande microélectronique (20),
➢ un banc d'éclairage (15) de la bande microélectronique (20),
➢ des moyens de calcul (40) aptes à délivrer, à partir des images captées par les caméras (11, 12), un diagnostic sur la présence ou non de défauts et une caractérisation des défauts.

2. Système selon la revendication 1, **caractérisé en ce qu'**il comprend en outre un deuxième sous-système (S2) dédié à l'inspection de la face puce des modules (21), et **en ce que** ce deuxième sous-système comprend :
➢ au moins deux caméras (13, 14), chaque caméra étant apte à visualiser la face puce de chaque module (21) disposé sur une première rangée (22) de modules, respectivement une deuxième rangée (23) de modules, de la bande microélectronique (20),
➢ un banc d'éclairage (16) de la bande microélectronique (20),
➢ des moyens de calcul (45) aptes à délivrer, à partir des images captées par les caméras (13, 14), un diagnostic sur la présence ou non de défauts et une caractérisation des défauts.

3. Système selon la revendication 1 ou 2, **caractérisé en ce qu'**il comporte en outre un support de bande (17) commun aux deux sous-systèmes (S1, S2).

4. Système selon la revendication 1 ou 2, **caractérisé en ce que** les caméras (11, 12 ; 13, 14) de chaque sous-système (S1 ; S2) sont montées selon une architecture de type pipeline.

5. Système selon l'une quelconque des revendications 1 à 4, **caractérisé en ce que** les deux caméras (11, 12 ; 13, 14) de chaque sous-système (S1 ; S2) sont maintenues fixes sur un support commun (18 ; 19).

6. Système selon l'une quelconque des revendications 1 à 5, dans lequel le banc d'éclairage (15 ; 16) comprend :
- un premier moyen (25 ; 27) de rétro-éclairage dédié à éclairer des index de référence (24) de la bande (20),
- un deuxième moyen (26 ; 28) d'éclairage dédié à la mise en évidence de défauts visuels, et
- un moyen de pilotage des deux moyens d'éclairage.

7. Système selon la revendication 6, dans lequel le moyen (25 ; 27) de rétro éclairage dédié aux index de référence comprend :
- une plaque de diffusion (30) destinée à diffuser la lumière,
- une plaque filtre (31) comprenant d'une part des éléments opaques (32) disposés en regard des modules (21) à inspecter sur la bande, et d'autre part des trous débouchant (33) disposés en regard des index de référence (24) de la bande (20),
- une plaque d'éclairage (34) destinée à éclairer lesdites plaques (30, 31) et la bande (20) de manière uniforme.

8. Système selon la revendication 6, **caractérisé en ce que** le deuxième moyen (26 ; 28) d'éclairage dédié aux défauts visuels comprend un moyen (35) permettant une diffusion axiale de la lumière.

9. Système selon la revendication 1 et/ou 2, **caractérisé en ce qu'**il comprend en outre une unité centrale de gestion (50) en communication avec les moyens de calculs (40 ; 45) du (des) sous-système(s) (S1 ; S2).

10. Méthode de contrôle visuel automatique de modules électroniques (21) disposés sur une bande microélectronique (20), ladite méthode comprenant les étapes consistant à :
- paramétrer (100) la bande à analyser à partir de sa géométrie (110), de son apparence (111) et d'un niveau de qualité requis (112),
- définir (211) des zones d'inspection (Z) par rapport à des index de référence, chaque zone correspondant respectivement à la surface d'un module à analyser, et
- pour chaque zone d'inspection (Z):
➢ détecter la présence d'un défaut,
➢ estimer les dimensions du défaut détecté (218),
➢ caractériser le défaut détecté (219, 220),
➢ émettre un diagnostic sur le statut du module analysé (221).

11. Méthode selon la revendication 10, selon laquelle pour chaque zone d'inspection (Z), une étape préalable (212) consiste à décomposer la zone d'inspection en zones élémentaires (Ze) et à réaliser un masquage de zones élémentaires (29) à ne pas analyser.

12. Méthode selon la revendication 10 ou 11, selon laquelle l'estimation des dimensions d'un défaut consiste à sommer les dimensions des défauts connexes à au moins deux zones élémentaires adjacentes (218).

13. Méthode selon l'une des revendications 10 à 12, selon laquelle l'étape de caractérisation d'un défaut consiste à lui attribuer une qualification selon ses dimensions et selon son degré de visibilité.

14. Méthode selon l'une quelconque des revendications 10 à 13, selon laquelle les faces contact et puce des modules sont inspectées simultanément.

15. Méthode selon l'une quelconque des revendications 10 à 13, selon laquelle les faces contact et puce des modules sont inspectées de manière indépendante.
